**Europäisches Patentamt**

**European Patent Office**

**Office européen des brevets**

(19)

(11) Veröffentlichungsnummer: **0 282 801 B1**

## (12) EUROPÄISCHE PATENTSCHRIFT

(45) Veröffentlichungstag der Patentschrift: **29.04.92**

(51) Int. Cl.5: **H04B 10/00**, H03G 3/20

(21) Anmeldenummer: **88103011.8**

(22) Anmeldetag: **29.02.88**

(54) Regelung des Multiplikationsfaktors von Lawinenphotodioden in optischen Empfängern.

(30) Priorität: **17.03.87 DE 3708665**

(43) Veröffentlichungstag der Anmeldung:
**21.09.88 Patentblatt 88/38**

(45) Bekanntmachung des Hinweises auf die
Patenterteilung:
**29.04.92 Patentblatt 92/18**

(84) Benannte Vertragsstaaten:
**BE DE FR GB IT NL**

(56) Entgegenhaltungen:
EP-A- 0 054 571
FR-A- 2 490 404
US-A- 4 015 118

PATENT ABSTRACTS OF JAPAN, Band 2, Nr.
139, 17. November 1978, Seite 8569 E 78; &
JP-A-53 105 903 (NIPPON DENKI K.K.)
14-09-1978

(73) Patentinhaber: **SIEMENS AKTIENGESELL-
SCHAFT
Wittelsbacherplatz 2
W-8000 München 2(DE)**

(72) Erfinder: **Burgmeier, Jürgen, Dipl.-Ing.
Flossmannstrasse 2 a
W-8000 München 60(DE)**
Erfinder: **Ouirin, Franz-Josef, Dipl.-Ing.
Am Lehwinkel 15
W-8000 München 71(DE)**

**Beschreibung**

Die Erfindung betrifft einen optischen Empfänger mit einer Lawinenfotodiode und einer Regeleinrichtung für deren Vorspannung und damit deren Multiplikationsfaktor in Abhängigkeit von der Dämpfung eines zusätzlich an der Lawinenfotodiode anliegenden niederfrequenten Signals vergleichsweise geringer Amplitude, wobei die Regeleinrichtung einen Niederfrequenzgenerator, einer Gleichrichteranordnung mit nachgeschalteten Verstärker und eine mit dem einen Anschluß der Lawinenfotodiode verbundene Vorspannungsquelle enthält und mit dem anderen Anschluß der Lawinenfotodiode ein Empfangsverstärker verbunden ist.

Beim praktischen Einsatz empfindlicher optischer digitaler Empfänger, in denen Lawinenphotodioden als Lichtdetektoren verwendet werden, besteht die Notwendigkeit, im Bereich kleiner Lichtleistungen den Lawinenmultiplikationsfaktor über die Vorspannung so zu regeln, daß sich eine minimale Bitfehlerquote ergibt. Der optimale Lawinenmultiplikationsfaktor ist abhängig von unterschiedlichen technologischen Parametern, z. B. dem Volumendunkelstrom und der Durchbruchspannung der Diode, sowie von unterschiedlichen Betriebsparametern, die z.T. auch die technologischen Parameter verändern. Zu diesen Betriebsparametern zählt die Empfangslichtleistung und insbesondere die Betriebstemperatur, da sich der Volumendunkelstrom bei Lawinenphotodioden aus Germanium pro 8° C Temperaturerhöhung verdoppelt.

Aus der EP-A1-0054571 ist bereits eine Anordnung zur Regelung des Multiplikationsfaktors von Lawinenphotodioden bekannt. Bei dieser Anordnung wird das Produkt aus dem Spitzenwert des primären Photostroms und dem Multiplikationsfaktor der Lawinenphotodiode durch eine Regelschaltung im kritischen unteren Bereich der verarbeitbaren Empfangslichtleistung über die Diodenvorspannung konstant gehalten. Der unmittelbar mit der Lawinenphotodiode verbundene Verstärker ist dabei mit in die Regelung einbezogen, so daß Veränderungen des Verstärkers die Regelung beeinflussen können. Dies ist von Bedeutung, da der Multiplikationsfaktor der Lawinenphotodiode durch ihre Vorspannung bestimmt wird, der Zusammenhang zwischen Vorspannung und Multiplikationsfaktor im interessierenden Bereich jedoch sehr nichtlinear ist, so daß an die Regelung und deren Grundabgleich hohe Genauigkeitsanforderungen gestellt werden müssen. Zu diesen Forderungen gehört auch, daß die herstellungsbedingt streuenden Parameter möglichst ohne speziellen Abgleich berücksichtigt werden, damit die Bitfehlerquote bei den verwendeten Lawinenphotodioden über den Bereich kleiner Lichtleistung minimal ist. Auch muß gewährleistet sein, daß bei sich im Laufe des Betriebes ändernden Diodenparametern die Bitfehlerquote im Bereich kleiner Lichtleistung so klein wie möglich bleibt. Dabei soll die Bitfehlerquote im Bereich kleiner Lichtleistungen innerhalb eines möglichst großen Temperaturintervalls minimal bleiben, und der Aufbau einer derartigen Anordnung soll mit geringem Aufwand möglich sein.

Es sind auch bereits Verfahren zur Regelung von Lawinenphotodioden bekannt, bei denen eine temperaturgesteuerte Vorspannung über einen Vorwiderstand zugeführt wird. Derartige Verfahren sind sehr empfindlich gegenüber Veränderungen des Oberflächendunkelstromes der Lawinenphotodiode, da Veränderungen des Oberflächendunkelstromes zu Veränderungen des Spannungsabfalles am Vorwiderstand führen und damit auch zu Veränderungen des Multiplikationsfaktors.

Aus den Patent Abstracts Of Japan, Band 2, Nr. 139, 17. November 1978, Seite 8569 E 78; & JP-A-53 105 903 (Nippon Denki K.K.) 14-09-1978 ist ein optischer Empfänger mit einer Lawinenfotodiode und einer Regeleinrichtung für deren Multiplikationsfaktor durch Regelung der Vorspannung der Lawinenfotodiode bekannt. Die bekannte Regeleinrichtung enthält einen Niederfrequenzoszillator zur Erzeugung eines gegenüber den Nutzsignal vergleichsweise niederfrequenten Signals kleiner Amplitude. Dieses niederfrequente Signal wird der Vorspannung der Lawinenfotodiode überlagert und der Strom durch die Fotodiode mittels eines dem Eingang des Empfangsverstärkers parallelgeschalteten Widerstandes gemessen. Dazu ist mit dem Widerstand ein erster Anschluß einer Schaltung direkt und ein weiterer Anschluß über einen Verstärker und eine Gleichrichterschaltung verbunden, außerdem ist ein Ausgang des Niederfrequenzgenerators über einen weiteren Verstärker und einem weiteren Gleichrichter mit einem dritten Eingang der Arithmetikschaltung verbunden, deren Ausgangssignal der für die Erzeugung der Vorspannung der Lawinenfotodiode vorgesehenen Konstantspannungsquelle zugeführt wird.

Dem Eingang des der Lawinenfotodiode nachgeschalteten Fotostromverstärkers sind damit ein Festwiderstand, ein Eingang der Arithmetikschaltung und ein Eingang eines Verstärkers parallelgeschaltet, so daß sich für die hochfrequenten elektrischen Signale eine unerwünschte Stromverzweigung und eine Erhöhung der Rauschspannung am Eingang des Fotostromverstärkers und damit eine Verringerung der Empfindlichkeit des optischen Empfängers gibt. Außerdem können sich durch die Vielzahl der Hochfrequenz führenden Bauteile unerwünschte Einstreuungen und Verkopplungen ergeben.

Die Erfindung stellt sich also die Aufgabe, einen optischen Empfänger der eingangs erwähnten Art zu entwickeln, der hinsichtlich der Empfindlichkeit und dem Schutz gegen Einstreuungen und Verkopplungen hohe Ansprüche erfüllt.

Erfindungsgemäß wird die Aufgabe bei einem optischen Empfänger der eingangs erwähnten Art dadurch gelöst, daß dieser durch die im Kennzeichen des Patentanspruchs 1 angegebenen Merkmale ausgebildet ist. Zweckmäßige Weiterbildungen des erfindungsgemäßen optischen Empfängers sind in den Patentansprüchen 2 und 3 beschrieben.

Die Erfindung soll im folgenden anhand eines in der Zeichnung dargestellten Ausführungsbeispiels näher erläutert werden. Dabei zeigt

Fig. 1 das Prinzipschaltbild einer erfindungsgemäßen Anordnung zur Regelung des Multiplikationsfaktors von Lawinenphotodioden und

Fig. 2 eine Darstellung der Kennlinie der Lawinenphotodiode.

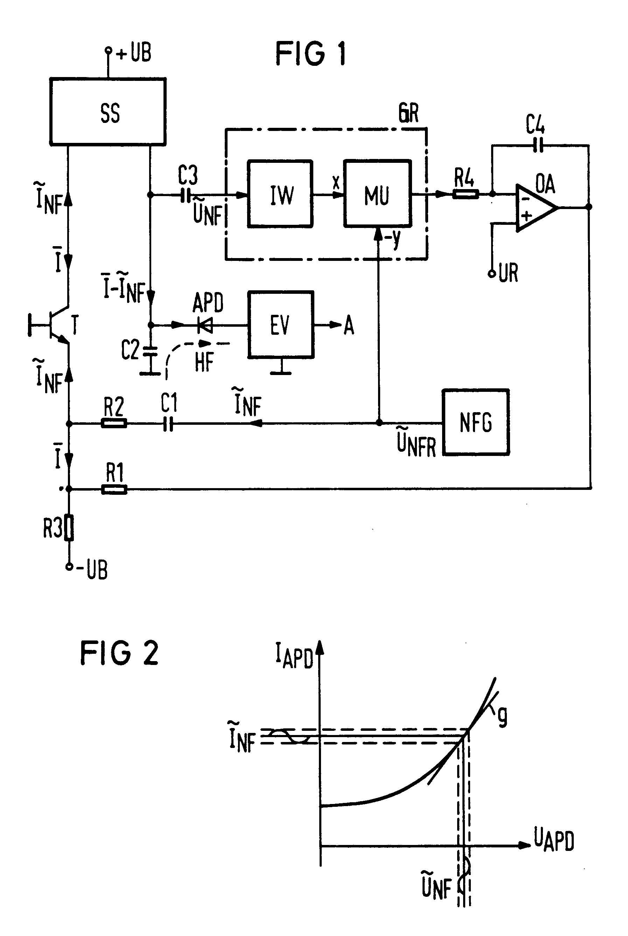

In Fig. 1 ist die Lawinenphotodiode APD optisch an eine Signallichtquelle angekoppelt, deren Licht in ein elektrisches Signal umgeformt, von einem nachgeschaltetem Empfangsverstärker EV verstärkt und an einem Ausgang A dieses Verstärkers abgegeben wird. Die Anode der Lawinenphotodiode APD liegt am Eingang des Empfangsverstärkers EV und damit für Wechselsignale niederohmig auf Bezugspotential, da beim Ausführungsbeispiel als Empfangsverstärker EV ein Transimpedanzverstärker vorgesehen ist. Die zur Einleitung des Lawineneffektes vergleichsweise hohe Vorspannung wird der Lawinenphotodiode APD über eine Stromspiegelschaltung SS zugeführt, die an eine positive Betriebsspannungsquelle + UB angeschlossen ist. Der nicht mit der Lawinenphotodiode APD verbundene Stromweg der Stromspiegelschaltung ist mit dem Kollektoranschluß eines Transistors T verbunden, dessen Basisanschluß an Bezugspotential liegt und dessen Emitteranschluß über einen ersten Widerstand R1 mit dem Ausgangsanschluß eines Operationsverstärkers OA, über einen zweiten Widerstand R2 und einen ersten Kondensator C1 mit dem Ausgangsanschluß eines Niederfrequenz-Generators NFG und über einen dritten Widerstand R3 mit einem Anschluß einer Quelle für eine negative Betriebsspannung - UB verbunden ist. Der mit der Lawinenphotodiode APD verbundene Stromweg der Stromspiegelschaltung SS ist über einen zweiten Kondensator C2, der für die Hochfrequenzsignale durchlässig und für das Niederfrequenzsignal undurchlässig ist, mit Bezugspotential verbunden. Außerdem ist an diesen Stromweg über einen dritten Kondensator C3, der für das niederfrequente Signal durchlässig ist, eine Gleichrichteranordnung GR angeschlossen. Der Ausgang der Gleichrichteranordnung GR ist über einen vierten Widerstand R4 mit dem invertierenden Eingang eines Operationsverstärkers OA verbunden, dessen nichtinvertierender Eingang an eine Referenzspannungsquelle UR angeschlossen ist. Der Ausgang dieses Operationsverstärkers ist zusätzlich über einen vierten Kondensator C4 mit dem invertierenden Eingang des Operationsverstärkers verbunden, so daß dieser als Integrator arbeitet.

Beim Ausführungsbeispiel ist die Gleichrichteranordnung als Synchrongleichrichter ausgeführt. Im Anschluß an einen eingangsseitigen Impedanzwandler IW ist ein Multiplizierer MU angeordnet, dessen x-Eingang mit dem Ausgang des Impedanzwandlers und dessen invertierender y-Eingang mit dem Ausgang des Niederfrequenz-Generators NFG verbunden ist. Der Ausgang des Multiplizierers stellt den Ausgang der Gleichrichteranordnung GR dar.

Die der Erfindung zugrunde liegende Anordnung beruht darauf, daß die Vorspannung der Lawinenphotodiode geregelt wird, wobei im Strom-Spannungsarbeitspunkt der Diode der differenzielle Leitwert g konstant gehalten wird. In der Fig. 2 ist die Abhängigkeit zwischen niederfrequentem Strom und niederfrequenter Spannung an der Lawinenphotodiode dargestellt. Der differentielle Leitwert ergibt sich dabei aus

$$g = \frac{I_{NFSS}}{U_{NFSS}} .$$

Der gemittelte Strom der Lawinenphotodiode setzt sich im wesentlichen aus dem Oberflächendunkelstrom, dem multiplizierten Volumendunkelstrom und dem gemittelten multiplizierten primären Photosignalstrom zusammen. Das Regelkriterium wird nun durch Überlagerung eines gegenüber dem Nutzsignal vergleichsweise sehr niederfrequenten Stromes $\tilde{i}_{NF}$ geringer Amplitude und der daraus resultierenden Spannungs $\tilde{u}_{NF}$ gewonnen. Das Verhältnis zwischen der Strom- und der Spannungsamplitude repräsentiert dabei den differentiellen Leitwert g, also die Regelgröße. Zu diesem Zweck ist der Niederfrequenz-Generator NFG vorgesehen, der einen vergleichsweise niederfrequenten Strom $\tilde{i}_{NF}$ über den ersten Kondensator C1 und den zweiten Widerstand R2 in denjenigen Stromweg des Stromspiegels SS einspeist, der nicht mit der Lawinenphotodiode verbunden ist. Durch die Spiegelung des niederfrequenten Stromes im Stromspiegel ergibt sich ein entsprechender niederfrequenter Strom $\tilde{i}_{NF}$ durch die Lawinenphotodiode APD, dieser Strom führt zu einem entsprechenden Spannungsabfall $\tilde{u}_{NF}$, der in der Gleichrichteranordnung GR detektiert wird. Im Hinblick auf eine möglichst präzise und störunempfindliche Regelung ist die Gleichrich-

3

teranordnung GR als Synchrongleichrichter ausgelegt, in dem ihr zusätzlich die Ausgangsspannung $\tilde{U}$ NFR des Niederfrequenz-Generators an einem weiteren Eingang invertiert zugeführt wird Bei geringeren Ansprüchen an die Genauigkeit der Regelung kann die Gleichrichteranordnung GR auch als Reihenschaltung aus Impedanzwandler und einfachem Gleichrichter aufgebaut sein. Das Ausgangssignal der Gleichrichteranordnung GR gelangt über den vierten Widerstand R4 an den invertierenden Eingang des Operationsverstärkers OA, der durch den Kondensator C4 als Integrator wirkt, und an dessem nichtinvertierenden Eingang eine Referenzspannung UR anliegt, die dem Sollwert des differenziellen Leitwertes der Photodiode entspricht. Der Ausgangsstrom des Operationsverstärkers OA wird über den ersten Widerstand R1 in den nicht mit der Lawinenphotodiode APD verbundenen Stromweg des Stromspiegels SS eingespeist und führt zu einer entsprechenden Änderung des der Lawinenphotodiode zugeführten Vorstroms I, bzw. der entsprechenden Vorspannung.

Die Regelung basiert auf dem bekannten Zusammenhang zwischen dem Multiplikationsfaktor M und der Vorspannung $U_{APD}$ der Lawinenphotodiode APD:

$$M = \frac{1}{1 - \left[ \dfrac{U_{APD}}{U_{BR} \ (1 + \gamma \ \Delta T)} \right]^{n}}$$

wobei

$U_{BR}$ = Lawinendurchbruchspannung bei 25° C
$\gamma$ = Temperaturkoeffizient der Durchbruchspannung
$\Delta T$ = Temperatur - 25° C
$n$ = Miller-Index ist.

Bei einem gegebenen Eingangssignal und einem bestimmten Volumendunkelstrom der Lawinenphotodiode, sowie einem bestimmten Multiplikationsfaktor M gilt für den Leitwert g der Lawinenphotodiode APD:

$$g \sim \frac{n}{(1 + \gamma \ \Delta T) \ U_{BR}}$$

Es hat sich gezeigt, daß in den meisten Anwendungsfällen, bei denen die Charakteristika der eingesetzten Dioden innerhalb einer gewissen Bandbreite liegen, auf einen speziellen Abgleich verzichtet werden kann. Eine Erhöhung der Genauigkeit kann dadurch erzielt werden, daß der Solleitwert entsprechend dem vorstehend gezeigten Zusammenhang dem Wert für die Lawinendurchbruchsspannung der jeweiligen Diode angepaßt wird. Der Wert der Durchbruchsspannung wird im allgemeinen vom Hersteller angegeben, so daß sich hieraus nur ein geringer Zusatzaufwand ergibt, auch ist eine vergleichsweise unkritische Temperatursteuerung des Solleitwertes der Lawinenphotodiode möglich.

Die in der Fig. 1 dargestellte Prinzipschaltung kann auch so modifiziert werden, daß statt der Einprägung eines konstanten Wechselstroms in die Lawinenphotodiode und der Auswertung der daraus resultierenden Wechselspannung auch eine Wechselspannung eingeprägt und der daraus sich ergebende Wechselstrom detektiert wird. Bei vielen Anwendungsfällen ist für + $U_B$ ein Gleichspannungswandler erforderlich, der die für die Lawinenphotodiode benötigte vergleichsweise hohe Gleichspannung über eine Wechselrichtung erzeugt. Die Restwelligkeit dieses Gleichspannungswandlers kann nun als niederfrequentes Signal verwendet werden, so daß in diesem Falle auf den NF-Generator NFG verzichtet werden kann.

Bei hohen Eingangslichtleistungen kann es zu einer Überschreitung des Stellbereiches der Regelung kommen. In diesem Falle kann zweckmäßigerweise eine einfache Klemmschaltung vorgesehen werden, die über einen Widerstand so in die APD-Versorgung eingreift, daß bei großer Lichtleistung der Multiplikationsfaktor der Lawinenphotodiode auf 1 gehalten wird.

**Patentansprüche**

1. Optischer Empfänger mit einer Lawinenfotodiode (APD) und einer Regeleinrichtung für deren Vorspannung und damit deren Multiplikationsfaktor in Abhängigkeit von Dämpfung eines zusätzlich an der Lawinenfotodiode (APD) anliegenden niederfrequenten Signals vergleichsweise geringer Amplitude, wobei die Regeleinrichtung einen Niederfrequenz-Generator (NFG), eine Gleichrichteranordnung (GR) mit nachgeschaltetem Verstärker (OA) und eine mit dem einen Anschluß der Lawinenfotodiode (APD) verbundene Vorspannungsquelle (SS) enthält und mit dem anderen Anschluß der Lawinenfotodiode (APD) ein Empfangsverstärker (EV) verbunden ist,
**dadurch gekennzeichnet,**
daß die Vorspannungsquelle als Stromspiegelschaltung (SS) mit zwei Anschlüssen ausgebildet ist und mit einem Anschluß der NiederfrequenzGenerator (NFG) und mit dem anderen Anschluß die Lawinenfotodiode (APD) und die Gleichrichteranordnung (GR) verbunden sind, daß der Ausgang der Gleichrichteranordnung (GR) mit dem einen Eingang eines als Integrator geschalteten Operationsverstärkers (OA) verbunden ist, daß der andere Eingang des Operationsverstärkers (OA) mit einer Referenzspannungsquelle (UR) verbunden ist und der Ausgang des Operationsverstärkers (OA) über einen ersten Widerstand (R1) mit demjenigen Stromweg der Stromspiegelschaltung (SS) verbunden ist, an dem die Lawinenfotodiode (APD) nicht angeschlossen ist.

2. Optischer Empfänger nach Patentanspruch 1,
**dadurch gekennzeichnet,**
daß die Gleichrichteranordnung (GR) eingangsseitig einen Impedanzwandler (IW) enthält, an dessen Ausgang der eine Eingang eines Multiplizierers (MU) angeschlossen ist, während der andere Eingang dieses Multiplizierers (MU) invertierend ist und mit dem Ausgang des Niederfrequenzgenerators (NFG) verbunden ist und der Ausgang des Multiplizierers (MU) den Ausgang der Gleichrichteranordnung (GR) darstellt.

3. Optischer Empfänger nach Patentanspruch 1,
**dadurch gekennzeichnet,**
daß die Stromspiegelschaltung (SS) einerseits mit einem Anschluß für die positive Betriebsspannung (+ UB) verbunden ist und andererseits über einen ersten Stromweg mit dem Kollektoranschluß eines Transistors (T) verbunden ist, dessen Basisanschluß an Masse angeschlossen ist,
daß der Emitteranschluß dieses Transistors über die Reihenschaltung aus einem zweiten Widerstand (R2) und einem ersten Kondensator (C1) mit dem Ausgang des NF-Generators (NFG), über einen ersten Widerstand (R1) mit dem Ausgang des Operationsverstärkers (OA) und über einen dritten Widerstand (R3) mit einem Anschluß einer Quelle für eine negative Betriebsspannung (- UB) verbunden ist,
daß der zweite Stromweg des Stromspiegelschaltung (SS) mit der Gleichrichteranordnung (GR), der Lawinen-Photodiode (APD) und über einen zweiten Kondensator (C2) mit Bezugspotential verbunden ist.

**Claims**

1. Optical receiver comprising an avalanche photodiode (APD) and a device for regulating its bias voltage and thus its multiplication factor in dependence on the attenuation of a low-frequency signal of comparatively low amplitude which is additionally present at the avalanche photodiode (APD), the regulating device containing a low-frequency generator (NFG), a rectifier arrangement (GR) followed by an amplifier (OA), and a bias voltage source (SS) connected to one terminal of the avalanche photodiode (APD), and a receiving amplifier (EV) connected to the other terminal of the avalanche photodiode (APD), characterised in that the bias voltage source is constructed as a current balancing circuit (SS) having two terminals and a low-frequency generator (NFG) is connected to one terminal and the avalanche photodiode (APD) and the rectifier arrangement (GR) are connected to the other terminal, that the output of the rectifier arrangement (GR) is connected to one input of an operational amplifier (OA) connected as integrator, that the other input of the operational amplifier (OA) is connected to a reference voltage source (UR) and the output of the operational amplifier (OA) is connected via a first resistor (R1) to the respective current path of the current balancing circuit (SS) to which the avalanche photodiode (APD) is not connected.

2. Optical receiver according to Claim 1, characterised in that the rectifier arrangement (GR) contains at the input an impedance converter (IW) to the output of which one input of a multiplier (MU) is connected whilst the other input of this multiplier (MU) is inverting and is connected to the output of the low-frequency generator (NFG) and the output of the multiplier (MU) represents the output of the rectifier arrangement (GR).

3. Optical receiver according to Claim 1, characterised in that the current balancing circuit (SS) is connected, on the one hand, to a terminal for the positive operating voltage (+ UB) and, on the other hand, is connected via a first current path to the collector terminal of a transistor (T), the base terminal of which is connected to earth, that the emitter terminal of this transistor is connected via the series circuit of a second resistor (R2) and a first capacitor (C1) to the output of the low-frequency generator (NFG), via a first resistor (R1) to the output of the operational amplifier (OA) and via a third resistor (R3) to one terminal of a source for a negative operating voltage (- UB), that the second current path of the current balancing circuit (SS) is connected to the rectifier arrangement (GR), the avalanche photodiode (APD) and via a second capacitor (C2) to reference potential.

**Revendications**

1. Récepteur optique comportant une photodiode à avalanche (APD) et un dispositif de régulation servant à régler la tension de polarisation de cette diode et par conséquent son facteur multiplicatif en fonction de l'affaiblissement d'un signal à basse fréquence, qui est appliqué en supplément à la photodiode à avalanche (APD) et possède une amplitude comparativement faible, et dans lequel le dispositif de régulation comporte un générateur de basses fréquences (NFG), un dispositif redresseur (GR) en aval duquel est branché un amplificateur (OA), et une source de tension de polarisation (SS) raccordée à une borne de la photodiode à avalanche (APD), et à un amplificateur de réception (FV) est raccordé à l'autre borne de la photodiode à avalanche (APD),
caractérisé par le fait
que la source de tension de polarisation est réalisée sous la forme d'un circuit formant miroir de courant (SS) comportant deux bornes et que le générateur de basses fréquences (NFG) est raccordé à une borne et la photodiode à avalanche (APD) et le dispositif redresseur (GR) sont raccordés à l'autre borne, que la sortie du dispositif redresseur (GR) est raccordée à une entrée d'un amplificateur opérationnel (OA) branché en tant qu'intégrateur, que l'autre entrée de l'amplificateur opérationnel (OA) est raccordée à une source de tension de référence (UR) et que la sortie de l'amplificateur opérationnel (OA) est raccordée par l'intermédiaire d'une première résistance (R1) à la voie de courant du circuit formant miroir de courant (SS), à laquelle n'est pas raccordée la photodiode à avalanche (APD).

2. Récepteur optique suivant la revendication 1,
caractérisé par le fait que le dispositif redresseur (GR) comporte, côté entrée, un transformateur d'impédances (IW), à la sortie duquel est raccordée une entrée d'un multiplicateur (MU), tandis que l'autre entrée de ce multiplicateur (MU) est une entrée inverseuse et est raccordée à la sortie du générateur de basses fréquences (NFG) et que la sortie du multiplicateur (MU) représente la sortie du dispositif redresseur (GR).

3. Récepteur optique suivant la revendication 1,
caractérisé par le fait
que le circuit formant miroir de courant (SS) est raccordé d'une part à une borne pour la tension de service positive (+UB) et d'autre part, par l'intermédiaire d'une première voie de courant, à la borne de collecteur d'un transistor (T), dont la borne de base est raccordée à la masse, que la borne d'émetteur de ce transistor est raccordée par l'intermédiaire du circuit série formé d'une seconde résistance (R2) et d'un premier condensateur (C1), à la sortie du générateur de basses fréquences (NFG), et par l'intermédiaire d'une première résistance (R1) à la sortie du premier amplificateur opérationnel (OA), et par l'intermédiaire d'une troisième résistance (R3) à une borne d'une source pour délivrer une tension de service négative (-UB), que la seconde voie de courant du circuit formant miroir de courant (SS) est raccordée au dispositif redresseur (GR), à la photodiode à avalanche (APD) et, par l'intermédiaire d'un second condensateur (C2), au potentiel de référence.

# FIG 1

# FIG 2